# EUROPEAN PATENT SPECIFICATION

(11) **EP 3 480 612 B1**
(45) Date of publication and mention of the grant of the patent: **30.12.2020**
(21) Application number: 18744772.7
(22) Date of filing: 23.01.2018
(51) Int. Cl.: G01R 31/36, G01R 31/52, G01R 27/02

(54) **DEVICE AND METHOD FOR MEASURING INSULATION RESISTANCE OF BATTERY PACK BY USING NEGATIVE ELECTRODE RELAY**
VORRICHTUNG UND VERFAHREN ZUR MESSUNG DES ISOLATIONSWIDERSTANDS EINES BATTERIEPACKS MIT NEGATIVELEKTRODENRELAIS
DISPOSITIF ET PROCÉDÉ DE MESURE DE LA RÉSISTANCE D'ISOLATION D'UN BLOC-BATTERIE À L'AIDE D'UN RELAIS D'ÉLECTRODE NÉGATIVE

(30) Priority: 24.01.2017 KR 20170011122
(43) Date of publication of application: 08.05.2019
(73) Proprietor: LG Chem, Ltd., Seoul 07336 (KR)
(72) Inventor: SUNG, Chang Hyun, Daejeon 34122 (KR); EGUCHI, Yasuhito, Daejeon 34122 (KR)
(74) Representative: Plasseraud IP
(86) International application number: PCT/KR2018/000994
(87) International publication number: WO 2018/139830

(56) References cited:
- JP-A- 2011 252 827
- KR-A- 20130 059 107
- KR-A- 20130 128 597
- KR-A- 20150 084 532
- KR-B1- 101 470 552
- US-A1- 2013 314 097
- US-A1- 2014 084 933
- US-A1- 2016 025 816
- US-A1- 2016 096 433

## Description

### [Technical Field]

The present invention relates to an apparatus and a method of measuring insulation resistance of a battery pack by using a negative relay, and more particularly, to an apparatus and a method of measuring insulation resistance of a battery pack by using a negative relay, in which when insulation resistance of a battery pack is measured by using an insulation resistance meter (IRM) circuit, insulation resistance of the battery pack is measured in a state where only a negative relay is electrically conducted, not in a state where both a positive relay and a negative relay are electrically conducted, thereby decreasing a risk of electric shock when insulation resistance is measured in a state where an external insulation resistor of the battery pack is broken.

### [Background Art]

In general, in a battery management system (BMS) connected with a battery cell, when insulation resistance, particularly, insulation resistance positioned between a positive electrode and a negative electrode, of a battery pack is broken, there is risk in that leakage current is generated to cause electric shock during a measurement of insulation resistance, and thus there is concern that a usage time of a battery is decreased.

Accordingly, the BMS practically needs to periodically monitor insulation resistance of a battery pack through an insulation resistance meter circuit (IRM circuit).

In the meantime, the IRM circuit measures a voltage by connecting predetermined test resistance to a battery pack and then calculates insulation resistance based on the measured voltage, and in this case, in order to measure a resistance value of insulation resistance outside the battery pack, it is necessary to make both a positive relay and a negative relay be electrically conducted (close). However, when both the positive relay and the negative relay are electrically conducted in the state where the external insulation resistor is broken, there is concern that a risk of electric shock is generated due to a leakage current.

Prior art battery insulation resistance measurement is known from US2013/314097, US2016/025816, US2014/084933, and US2016/096433.

Accordingly, currently, there is actually a need for a method having stability which is capable of measuring external insulation resistance of a battery pack before both a positive relay and a negative relay are electrically conducted.

Accordingly, in order to solve various problems and limits generated during a process of measuring external insulation resistance of the battery pack in the related art, the present inventors developed an apparatus and a method of measuring insulation resistance of a battery pack by using a negative relay, in which when insulation resistance of a battery pack is measured by using an IRM circuit, insulation resistance of the battery pack is measured in a state where only a negative relay is electrically conducted, not in a state where both a positive relay and a negative relay are electrically conducted, thereby decreasing a risk of electric shock when insulation resistance is measured in a state where an external insulation resistor of the battery pack is broken.

### [Detailed Description of the Invention]

### [Technical Problem]

The present invention is conceived to solve the problems, and provides an apparatus and a method of measuring insulation resistance of a battery pack by using a negative relay, in which when insulation resistance of a battery pack is measured by using an insulation resistance meter (IRM) circuit, insulation resistance of the battery pack is measured in a state where only a negative relay is electrically conducted, not in a state where both a positive relay and the negative relay are electrically conducted, thereby decreasing a risk of electric shock when insulation resistance is measured in a state where an external insulation resistor of the battery pack is broken.

### [Technical Solution]

To solve this problem, the present invention provides an apparatus according to claim 1, and a corresponding method according to claim 4.

An exemplary embodiment of the present invention provides an apparatus for measuring insulation resistance of a battery pack by using a negative relay, the apparatus including: a measuring unit which measures resistance values of an internal positive insulation resistor and an internal negative insulation resistor connected to both ends of a battery pack; and a calculating unit which when a negative main relay, of which one side is connected with an external positive insulation resistor between the external positive insulation resistor and the external negative insulation resistor connected with a link capacitor and the other side is connected with the measuring unit, is electrically conducted (close), calculates resistance values of the external positive insulation resistor and the external negative insulation resistor, which are connected with the internal negative insulation resistor in parallel, based on the resistance values of the internal positive insulation resistor and the internal negative insulation resistor measured by the measuring unit.

In the exemplary embodiment, the measuring unit may measure the resistance values of the internal positive insulation resistor and the internal negative insulation resistor in advance in an open state that is before the negative main relay is electrically conducted and measure a parallel resistance value of the external positive insulation resistor and the external negative insulation resistor measured in the state where the negative main relay is electrically conducted.

In the exemplary embodiment, when the resistance values of the internal positive insulation resistor and the internal negative insulation resistor are measured by the measuring unit in the state where the negative main relay is electrically conducted, a parallel resistance value of the external positive insulation resistor and the external negative insulation resistor may be measured together.

In the exemplary embodiment, the calculating unit may calculate the resistance value of each of the external positive insulation resistor and the external negative insulation resistor based on the resistance value of the internal negative insulation resistor measured in advance when the negative main relay is in the open state that is before the negative main relay is electrically conducted, and the parallel resistance value of the external positive insulation resistor and the external negative insulation resistor measured in the state where the negative main relay is electrically conducted.

Another exemplary embodiment of the present invention provides a method of measuring insulation resistance of a battery pack by using a negative relay, the method including: measuring, by a measuring unit which is connected to an internal positive insulation resistor and an internal negative insulation resistor connected to both ends of a battery pack, resistance values of the internal positive insulation resistor and the internal negative insulation resistor; making a negative main relay, of which one side is connected with an external negative insulation resistor between an external positive insulation resistor and the external negative insulation resistor connected with a link capacitor and the other side is connected with the measuring unit, be electrically conducted (close); and calculating, by a calculating unit, resistance values of the external positive insulation resistor and the external negative insulation resistor, which are connected with the internal negative insulation resistor in parallel, based on measurement values obtained by measuring, by the measuring unit, the resistance values of the internal positive insulation resistor and the internal negative insulation resistor.

In the exemplary embodiment, the measuring of the resistance value of the internal negative insulation resistor may include measuring the resistance values of the internal positive insulation resistor and the internal negative insulation resistor in advance in the open state that is before the negative main relay is electrically conducted, and the making of the negative main relay be electrically conducted may include measuring a parallel resistance value of the external positive insulation resistor and the external negative insulation resistor in the state where the negative main relay is electrically conducted.

In the exemplary embodiment, the measuring of the resistance values of the external positive insulation resistor and the external negative insulation resistor in the state where the negative main relay is electrically conducted may include measuring the parallel resistance value of the external positive insulation resistor and the external negative insulation resistor together when the resistance values of the internal positive insulation resistor and the internal negative insulation resistor are measured by the measuring unit in the state where the negative main relay is electrically conducted.

In the exemplary embodiment, the calculating unit may calculate the resistance value of each of the external positive insulation resistor and the external negative insulation resistor based on the resistance value of the internal negative insulation resistor measured in advance when the negative main relay is in the open state that is before the negative main relay is electrically conducted, and the parallel resistance value of the external positive insulation resistor and the external negative insulation resistor measured in the state where the negative main relay is electrically conducted.

### [Advantageous effect]

According to one aspect of the present invention, when insulation resistance of a battery pack is measured by using an insulation resistance meter (IRM) circuit, insulation resistance of the battery pack is measured in a state where only a negative relay is electrically conducted, not in a state where both a positive relay and the negative relay are electrically conducted, so that it is possible to decrease a risk of electric shock when insulation resistance is measured in a state where an external insulation resistor of the battery pack is broken, thereby improving stability.

### [Brief Description of Drawings]

FIG. 1 is a diagram schematically illustrating a general process of measuring insulation resistance of a battery pack.
FIG. 2 is a diagram schematically illustrating a process of measuring insulation resistance (internal insulation resistance and external insulation resistance) of a battery pack in the related art.
FIG. 3 is a diagram schematically illustrating a process of measuring insulation resistance (internal insulation resistance and external insulation resistance) of a battery pack through an apparatus 100 for measuring insulation resistance of a battery pack by using a negative relay according to an exemplary embodiment of the present invention.
FIG. 4 is a flowchart sequentially illustrating a process of measuring insulation resistance of a battery pack through the apparatus 100 for measuring insulation resistance of a battery pack by using a negative relay according to the exemplary embodiment of the present invention.

### [Mode for carrying out the invention]

Hereinafter, an exemplary embodiment is presented for helping understanding of the present invention. However, the exemplary embodiment below is simply provided for easier understanding of the present invention, and the contents of the present invention are not limited by the exemplary embodiment.

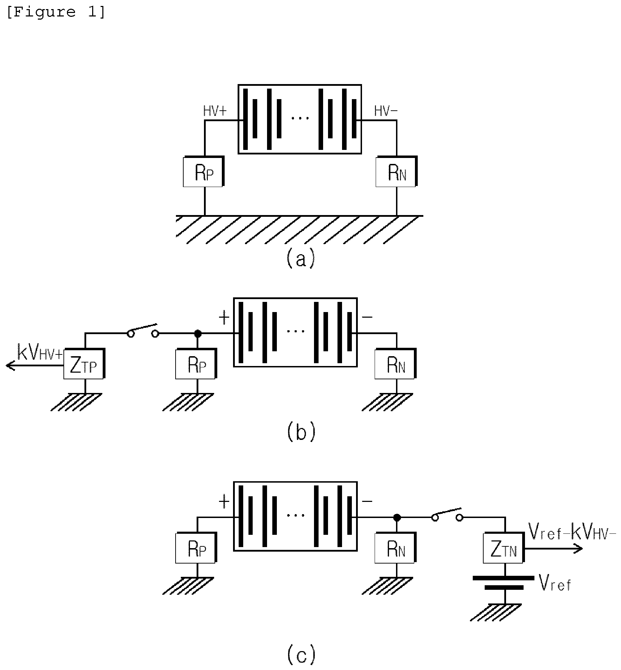

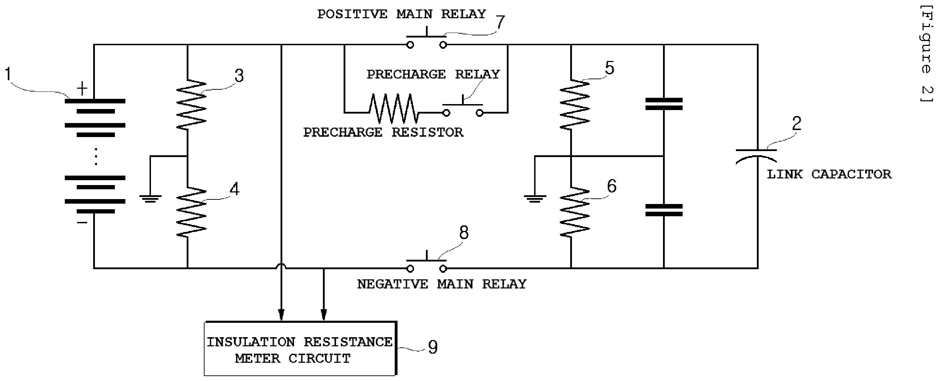

FIG. 1 is a diagram schematically illustrating a general process of measuring insulation resistance of a battery pack, and FIG. 2 is a diagram schematically illustrating a process of measuring insulation resistance (internal insulation resistance and external insulation resistance) of a battery pack in the related art.

First, referring to FIG. 1A, insulation resistance R_{P} and R_{N} are connected to a positive electrode HV+ and a negative electrode HV- of a battery pack in which one or more battery modules are combined, respectively.

In this case, in order to measure a resistance value of each insulation resistance, a method of connecting test resistance Z_{TP} and Z_{TN} through switches is used as illustrated in FIG. 1B, and in this case, the method includes two operations.

Referring to FIG. 1B, FIG. 1B illustrates an operation of measuring a positive side voltage, and a switch is connected between the insulation resistance R_{P} and the test resistance Z_{TP} connected to the positive electrode of the battery pack, and a voltage applied after the connection of the test resistance Z_{TP} is scaled down and measured.

Referring to FIG. 1C, FIG. 1C illustrates an operation of measuring a negative side voltage, and a switch is connected between the insulation resistance Rₙ and the test resistance Z_{TN} connected to the negative electrode of the battery pack, and a voltage applied after the connection of the test resistance Z_{TN} is scaled down and measured. In this case, a voltage reference (V reference) value is used so that the measured voltage value has a positive number.

Then, resistance values of the insulation resistance R_{P} and R_{N} are calculated by using the measured positive side and negative side voltage values.

Next, referring to FIG. 2, FIG. 2 is a diagram illustrating a process of measuring insulation resistance (internal insulation resistance and external insulation resistance) of a battery pack in the related art, and a battery pack 1 is provided at a left side of a circuit, a link capacitor 2 is provided at a right side of the circuit, an internal positive insulation resistor 3 and an internal negative insulation resistor 4 are connected to both ends of the battery pack 1 positioned at the left side, and the internal positive insulation resistor 3 and the internal negative insulation resistor 4 are serially connected to each other.

Further, the link capacitor 2 at the right side is connected to an external positive insulation resistor 5 and an external negative insulation resistor 6, and the external positive insulation resistor 5 and the external negative insulation resistor 6 are serially connected to each other.

It can be seen that a positive main relay 7 and a negative main relay 8 are positioned between the internal positive insulation resistor 3 and the internal negative insulation resistor 4, and between the external positive insulation resistor 5 and the external negative insulation resistor 6.

Further, a precharge resistor and a precharge relay are connected to both ends of the positive main relay 7 in parallel.

The positive main relay 7 and the negative main relay 8 are simultaneously electrically conducted (close), so that the battery pack 1 may be connected with the external positive insulation resistor 5 and the external negative insulation resistor 6 provided outside the battery pack.

In this case, a circuit connected from a terminal of each of the internal positive insulation resistor 3 and the internal negative insulation resistor 4 is connected with an insulation resistance meter circuit 9, and the insulation resistance meter circuit 8 serves to measure insulation resistance values of the internal positive insulation resistor 3, the internal negative insulation resistor 4, the external positive insulation resistor 5, and the external negative insulation resistor 6.

Accordingly, before the positive main relay 7 and the negative main relay 8 are electrically conducted, that is, in an open state, insulation resistance values of the internal positive insulation resistor 3 and the internal negative insulation resistor 4 are measured, and when the positive main relay 7 and the negative main relay 8 are electrically conducted (close), insulation resistance values of the external positive insulation resistor 5 and the external negative insulation resistor 6 are measured.

That is, in order to measure insulation resistance values of the external positive insulation resistor 5 and the external negative insulation resistor 6 by using the method in the related art, both the positive main relay 7 and the negative main relay 8 need to be electrically conducted, so that when both the positive main relay 7 and the negative main relay 8 are electrically conducted in the state where the external positive insulation resistor 5 and the external negative insulation resistor 6 are broken, a risk of electric shock may be generated due to the generation of a leakage current.

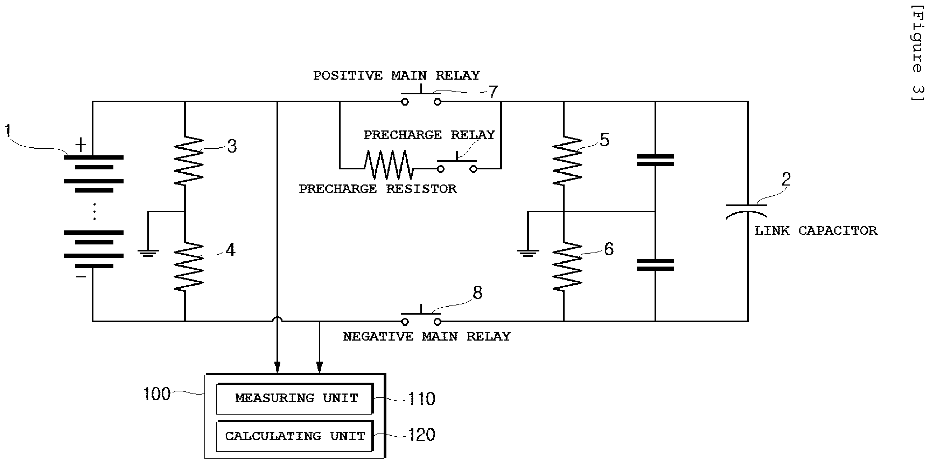

Accordingly, an apparatus 100 for measuring insulation resistance of a battery pack by using a negative relay, which is capable of measuring an insulation resistance value of a battery pack by using only a negative relay, of the present invention will be described with reference to FIG. 3.

FIG. 3 a diagram schematically illustrating a process of measuring insulation resistance (internal insulation resistance and external insulation resistance) of a battery pack through an apparatus 100 for measuring insulation resistance of a battery pack by using a negative relay according to an exemplary embodiment of the present invention.

Referring to FIG. 3, the apparatus 100 for measuring insulation resistance of a battery pack by using a negative relay according to the present invention may be connected with an internal positive insulation resistor 3 and an internal negative insulation resistor 4 connected to both ends of a battery pack 1, and a negative main relay 8 connected with the internal positive insulation resistor 5 and the internal negative insulation resistor 6.

In the meantime, it is noted that a circuit configuration adopting the apparatus 100 for measuring insulation resistance of a battery pack by using a negative relay according to the present invention may correspond to the circuit configuration of measuring insulation resistance of a battery pack in the related art illustrated in FIG. 2.

A measurement unit 110 connected with the internal positive insulation resistor 3 and the internal negative insulation resistor 4 measures resistance values of the internal positive insulation resistor 3 and the internal negative insulation resistor 4 in an initial state (the state where a positive main relay 7 and the negative main relay 8 are not electrically conducted) in advance, and a calculating unit 120 calculates a resistance value of each of an external positive insulation resistor 5 and an external negative insulation resistor 6 in the state where the negative main relay 8 is electrically conducted.

Further, when the resistance values of the internal positive insulation resistor 3 and the internal negative insulation resistor 4 are measured through the measurement unit 110 in the state where the negative main relay 8 is electrically conducted, parallel resistance values of the external positive insulation resistor 5 and the external negative insulation resistor 6 are also measured.

In the meantime, since the link capacitor 2 positioned at the output terminal in the state where the negative main relay 8 is electrically conducted is in a completely discharged state, and has large capacitance, a potential difference between both ends of the link capacitor 2 maintains 0.

Further, the resistance value of the internal negative insulation resistor 4 has been already measured before the negative main relay 8 is electrically conducted, so that it is possible to calculate a resistance value of each of the external positive insulation resistor 5 and the external negative insulation resistor 6 based on the previously measured resistance value of the internal negative insulation resistor 4 and the parallel resistance value of the external positive insulation resistor 5 and the external negative insulation resistor 6, which is possible because the external positive insulation resistor 5 and the external negative insulation resistor 6 are connected to the internal negative insulation resistor 4 in parallel.

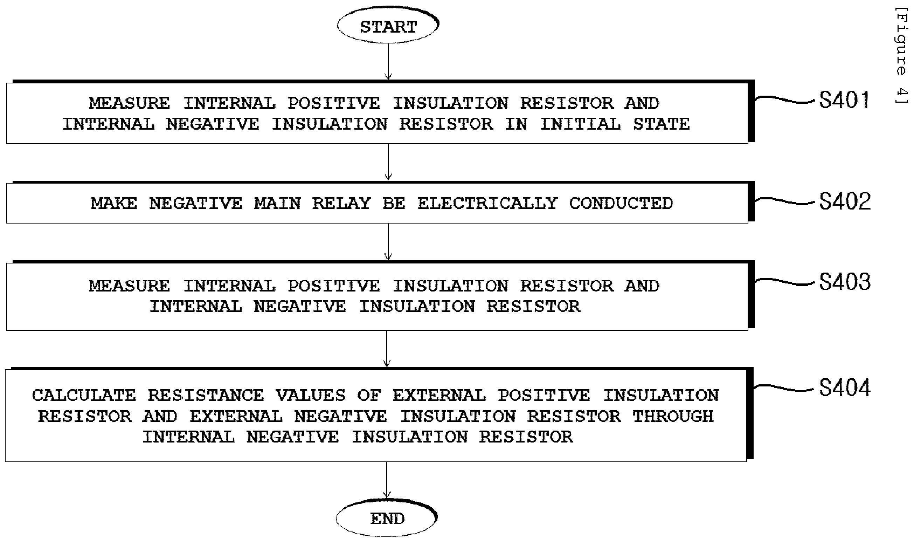

The process of measuring insulation resistance of the battery pack described with reference to FIG. 3 will be sequentially described with reference to FIG. 4.

FIG. 4 is a flowchart sequentially illustrating a process of measuring insulation resistance of a battery pack through the apparatus 100 for measuring insulation resistance of a battery pack by using a negative relay according to the exemplary embodiment of the present invention.

Referring to FIG. 4, first, in an initial state in which the negative main relay is not electrically conducted, the measuring unit measures resistance values of the internal positive insulation resistor and the internal negative insulation resistor (S401).

Next, after the negative main relay is electrically conducted (S402), when the resistance values of the internal positive insulation resistor and the internal negative insulation resistor are measured by the measuring unit in the state where the negative main relay is electrically conducted, a parallel resistance value of the external positive insulation resistor and the external negative insulation resistor, which are connected to the internal negative insulation resistor in parallel, is measured together (S403).

Next, the calculating unit calculates a resistance value of each of the external positive insulation resistor and the external negative insulation resistor, which are connected to the internal negative insulation resistor in parallel, based on the resistance value of the internal negative insulation resistor measured before the negative main relay is electrically conducted and the parallel resistance value measured after the negative main relay is electrically conducted (S404).

In the forgoing, the present invention has been described with reference to the exemplary embodiment of the present invention, but those skilled in the art may appreciate that the present invention may be variously corrected and changed within the range without departing from the present invention as defined by the claims.

## Claims

1. An apparatus (100) for measuring insulation resistance of a battery pack (1) connected to a negative main relay (8) and a positive main relay (7), the other sides of the main relays being connected to a link capacitor (2), the apparatus comprising:
a measuring unit (110) connected to both ends of the battery pack (1); and
a calculating unit (120);
wherein the measuring unit (110) measures the resistance values of an internal positive insulation resistor (3) and an internal negative insulation resistor (4) of the battery pack in advance in an open state where the negative main relay (8) and the positive main relay (7) are electrically non-conducting (open), and measures a parallel resistance value including an external positive insulation resistor (5) and an external negative insulation resistor (6), the external insulation resistors located at the link capacitor side of the main relays, in a state where the negative main relay (8) is electrically conducting (closed), and the positive main relay (7) is non-conducting (open); wherein the calculating unit (120) calculates the resistance values of the external insulation resistors based on the measured internal resistance values and the measured parallel resistance values.

2. The apparatus of claim 1, wherein when the resistance values of the internal positive insulation resistor (3) and the internal negative insulation resistor (4) are measured by the measuring unit (110) in the state where the negative main relay (8) is electrically conducted, a parallel resistance value of the external positive insulation resistor (5) and the external negative insulation resistor (6) is measured together.

3. The apparatus of claim 1, wherein the calculating unit (120) calculates the resistance value of each of the external positive insulation resistor (5) and the external negative insulation resistor (6) based on the resistance value of the internal negative insulation resistor (3) measured in advance when the negative main relay (8) is in the open state that is before the negative main relay (8) is electrically conducted, and the parallel resistance value of the external positive insulation resistor (5) and the external negative insulation resistor (6) measured in the state where the negative main relay (8) is electrically conducted.

4. A method of measuring insulation resistance of a battery pack (1) connected to a negative main relay (8) and a positive main relay (7), the other sides of the main relays being connected to a link capacitor (2), the method comprising:
Measuring (S401), by a measuring unit (110) which is connected to both ends of the battery pack (1), resistance values of an internal positive insulation resistor (3) and an internal negative insulation resistor (4) of the battery pack in advance in an open state where the negative main relay and the positive main relay are non-conducting (open);
causing (S402) the negative main relay to be in a conducting (closed) state, while the positive main relay is non-conducting (open); measuring (S403) a parallel resistance value including an external positive insulation resistor (5) and an external negative insulation resistor (6), the external insulation resistors located at the link capacitor side of the main relays;
calculating (S404) the resistance values of the external insulation resistors based on the measured values of the internal resistances and the measured parallel resistance value.

5. The method of claim 4, wherein the measuring of the resistance values of the external positive insulation resistor (5) and the external negative insulation resistor (6) in the state where the negative main relay (8) is electrically conducted includes measuring the parallel resistance value of the external positive insulation resistor (5) and the external negative insulation resistor (6) together when the resistance values of the internal positive insulation resistor (3) and the internal negative insulation resistor (4) are measured by the measuring unit (110) in the state where the negative main relay (8) is electrically conducted.

6. The method of claim 5, wherein the calculating unit (110) calculates the resistance value of each of the external positive insulation resistor (5) and the external negative insulation resistor (6) based on the resistance value of the internal negative insulation resistor (4) measured in advance when the negative main relay (8) is in the open state that is before the negative main relay (8) is not conducted, and the parallel resistance value of the external positive insulation resistor (5) and the external negative insulation resistor (6) measured in the state where the negative main relay (8) is electrically conducted.

## Patentansprüche

1. Vorrichtung (100) zum Messen eines Isolation-Widerstands eines Batteriepacks (1), welcher mit einem negativen Haupt-Relais (8) und einem positiven Haupt-Relais (7) verbunden ist, wobei die anderen Seiten der Haupt-Relais mit einem Verknüpfung-Kondensator (2) verbunden sind, wobei die Vorrichtung umfasst:
eine Messeinheit (110), welche mit beiden Enden des Batteriepacks (1) verbunden ist; und
eine Berechnungseinheit (120),
wobei die Messeinheit (110) die Widerstand-Werte eines internen positiven Isolation-Widerstands (3) und eines internen negativen Isolation-Widerstands (4) des Batteriepacks vorab in einem offenen Zustand misst, in welchem das negative Haupt-Relais (8) und das positive Haupt-Relais (7) elektrisch nicht-leitend (offen) sind, und einen parallelen Widerstand-Wert misst, umfassend einen externen positiven Isolation-Widerstand (5) und einen externen negativen Isolation-Widerstand (6), wobei die externen Isolation-Widerstände an der Seite des Verknüpfung-Kondensators der Haupt-Relais angeordnet sind, in einem Zustand, in welchem das negative Haupt-Relais (8) elektrisch leitend (geschlossen) ist, und das positive Haupt-Relais (7) nicht-leitend (offen) ist; wobei die Berechnungseinheit (120) die Widerstand-Werte der externen Isolation-Widerstände auf Grundlage der gemessenen internen Widerstand-Werte und der gemessenen parallelen Widerstand-Werte berechnet.

2. Vorrichtung nach Anspruch 1, wobei, wenn die Widerstand-Werte des internen positiven Isolation-Widerstands (3) und des internen negativen Isolation-Widerstands (4) durch die Messeinheit (110) in dem Zustand gemessen werden, in welchem das negative Haupt-Relais (8) elektrisch leitend ist, ein paralleler Widerstand-Wert des externen positiven Isolation-Widerstands (5) und des externen negativen Isolation-Widerstands (6) zusammen gemessen wird.

3. Vorrichtung nach Anspruch 1, wobei die Berechnungseinheit (120) den Widerstand-Wert von jedem aus dem externen positiven Isolation-Widerstand (5) und dem externen negativen Isolation-Widerstand (6) auf Grundlage des Widerstand-Werts des internen negativen Isolation-Widerstands (3), welcher vorab gemessen wird, wenn das negative Haupt-Relais (8) in dem offenen Zustand ist, das heißt bevor das negative Haupt-Relais (8) elektrisch leitend ist, und dem parallelen Widerstand-Wert des externen positiven Isolation-Widerstands (5) und des externen negativen Isolation-Widerstands (6) berechnet, welche in dem Zustand gemessen werden, in welchem das negative Haupt-Relais (8) elektrisch leitend ist.

4. Verfahren zum Messen eines Isolation-Widerstands eines Batteriepacks (1), welcher mit einem negativen Haupt-Relais (8) und einem positiven Haupt-Relais (7) verbunden ist, wobei die anderen Seiten der Haupt-Relais mit einem Verknüpfung-Kondensator (2) verbunden sind, wobei das Verfahren umfasst:
Messen (S401) durch eine Messeinheit (110), welche mit beiden Enden des Batteriepacks (1) verbunden ist, von Widerstand-Werten eines internen positiven Isolation-Widerstands (3) und eines internen negativen Isolation-Widerstands (4) des Batteriepacks vorab in einem offenen Zustand, in welchem das negative Haupt-Relais und das positive Haupt-Relais elektrisch nicht-leitend (offen) sind;
Veranlassen (S402) des negativen Haupt-Relais, in einem leitenden (geschlossen) Zustand zu sein, während das Haupt-Relais nicht-leitend (offen) ist; Messen (S403) eines parallelen Widerstand-Werts, umfassend einen externen positiven Isolation-Widerstand (5) und einen externen negativen Isolation-Widerstand (6), wobei die externen Isolation-Widerstände an der Seite des Verknüpfung-Kondensators der Haupt-Relais angeordnet sind;
Berechnen (S404) der Widerstand-Werte der externen Isolation-Widerstände auf Grundlage der gemessenen Werte der internen Widerstände und des gemessenen parallelen Widerstand-Werts.

5. Verfahren nach Anspruch 4, wobei das Messen der Widerstand-Werte des externen positiven Isolation-Widerstands (5) und des externen negativen Isolation-Widerstands (6) in dem Zustand, in welchem das negative Haupt-Relais (8) elektrisch leitend ist, ein Messen des parallelen Widerstand-Werts des externen positiven Isolation-Widerstands (5) und des externen negativen Isolation-Widerstands (6) zusammen umfasst, wenn die Widerstand-Werte des internen positiven Isolation-Widerstands (3) und des internen negativen Isolation-Widerstands (4) durch die Messeinheit (110) in dem Zustand gemessen werden, in welchem das negative Haupt-Relais (8) elektrisch leitend ist.

6. Verfahren nach Anspruch 5, wobei die Berechnungseinheit (110) den Widerstand-Wert von jedem aus dem externen positiven Isolation-Widerstand (5) und dem externen negativen Isolation-Widerstand (6) auf Grundlage des Widerstand-Werts des internen negativen Isolation-Widerstands (4), welcher vorab gemessen wird, wenn das negative Haupt-Relais (8) in dem offenen Zustand ist, das heißt bevor das negative Haupt-Relais (8) nicht-leitend ist, und dem parallelen Widerstand-Wert des externen positiven Isolation-Widerstands (5) und des externen negativen Isolation-Widerstands (6) berechnet, welche in dem Zustand gemessen werden, in welchem das negative Haupt-Relais (8) elektrisch leitend ist.

## Revendications

1. Appareil (100) pour mesurer la résistance d'isolation d'un bloc-batterie (1) connecté à un relais principal négatif (8) et un relais principal positif (7), les autres côtés des relais principaux étant connectés à un condensateur de liaison (2), l'appareil comprenant :
une unité de mesure (110) connectée aux deux extrémités du bloc-batterie (1) ; et
une unité de calcul (120) ;
dans lequel l'unité de mesure (110) mesure les valeurs de résistance d'une résistance d'isolation positive interne (3) et d'une résistance d'isolation négative interne (4) du bloc-batterie à l'avance dans un état ouvert où le relais principal négatif (8) et le relais principal positif (7) sont électriquement non conducteurs (ouverts), et mesure une valeur de résistance parallèle incluant une résistance d'isolation positive externe (5) et une résistance d'isolation négative externe (6), les résistances d'isolation externe étant situées du côté du condensateur de liaison des relais principaux, dans un état où le relais principal négatif (8) est électriquement conducteur (fermé), et le relais principal positif (7) est non conducteur (ouvert) ; dans lequel l'unité de calcul (120) calcule les valeurs de résistance des résistances d'isolation externe sur la base des valeurs de résistance interne mesurées et des valeurs de résistance parallèle mesurées.

2. Appareil selon la revendication 1, dans lequel quand les valeurs de résistance de la résistance d'isolation positive interne (3) et de la résistance d'isolation négative interne (4) sont mesurées par l'unité de mesure (110) dans l'état où le relais principal négatif (8) est électriquement conducteur, une valeur de résistance parallèle de la résistance d'isolation positive externe (5) et de la résistance d'isolation négative externe (6) est mesurée ensemble.

3. Appareil selon la revendication 1, dans lequel l'unité de calcul (120) calcule la valeur de résistance de chacune parmi la résistance d'isolation positive externe (5) et la résistance d'isolation négative externe (6) sur la base de la valeur de résistance de la résistance d'isolation négative interne (3) mesurée à l'avance quand le relais principal négatif (8) est dans l'état ouvert qui est avant que le relais principal négatif (8) ne soit électriquement conducteur, et la valeur de résistance parallèle de la résistance d'isolation positive externe (5) et de la résistance d'isolation négative externe (6) mesurée dans l'état où le relais principal négatif (8) est électriquement conducteur.

4. Procédé de mesure d'une résistance d'isolation d'un bloc-batterie (1) connecté à un relais principal négatif (8) et un relais principal positif (7), les autres côtés des relais principaux étant connectés à un condensateur de liaison (2), le procédé comprenant :
la mesure (S401), par une unité de mesure (110) qui est connectée aux deux extrémités du bloc-batterie (1), de valeurs de résistance d'une résistance d'isolation positive interne (3) et d'une résistance d'isolation négative interne (4) du bloc-batterie à l'avance dans un état ouvert où le relais principal négatif et le relais principal positif sont non conducteurs (ouverts) ;
le fait d'amener (S402) le relais principal négatif à être dans un état conducteur (fermé), tandis que le relais principal positif est non conducteur (ouvert) ; la mesure (S403) d'une valeur de résistance parallèle incluant une résistance d'isolation positive externe (5) et une résistance d'isolation négative externe (6), les résistances d'isolation externe étant situées du côté du condensateur de liaison des relais principaux ;
le calcul (S404) des valeurs de résistance des résistances d'isolation externe sur la base des valeurs mesurées de résistances internes et de la valeur de résistance parallèle mesurée.

5. Procédé selon la revendication 4, dans lequel la mesure des valeurs de résistance de la résistance d'isolation positive externe (5) et de la résistance d'isolation négative externe (6) dans l'état où le relais principal négatif (8) est électriquement conducteur inclut la mesure de la valeur de résistance parallèle de la résistance d'isolation positive externe (5) et de la résistance d'isolation négative externe (6) ensemble quand les valeurs de résistance de la résistance d'isolation positive interne (3) et de la résistance d'isolation négative interne (4) sont mesurées par l'unité de mesure (110) dans l'état où le relais principal négatif (8) est électriquement conducteur.

6. Procédé selon la revendication 5, dans lequel l'unité de calcul (110) calcule la valeur de résistance de chacune parmi la résistance d'isolation positive externe (5) et la résistance d'isolation négative externe (6) sur la base de la valeur de résistance de la résistance d'isolation négative interne (4) mesurée à l'avance quand le relais principal négatif (8) est dans l'état ouvert qui est avant que le relais principal négatif (8) ne soit pas conducteur, et la valeur de résistance parallèle de la résistance d'isolation positive externe (5) et de la résistance d'isolation négative externe (6) mesurée dans l'état où le relais principal négatif (8) est électriquement conducteur.
